# EUROPEAN PATENT SPECIFICATION

(11) **EP 0 914 697 B1**
(45) Date of publication and mention of the grant of the patent: **19.12.2001**
(21) Application number: 97936990.7
(22) Date of filing: 22.07.1997
(51) Int. Cl.: H01R 12/20, H01R 12/04

(54) **ASSEMBLY OF CONNECTOR AND PRINTED CIRCUIT BOARD**
VERBINDER-LEITERPLATTENANORDNUNG
ASSEMBLAGE D'UN CONNECTEUR ET D'UNE PLAQUETTE DE CIRCUIT IMPRIME

(30) Priority: 22.07.1996 JP 21204996
(43) Date of publication of application: 12.05.1999
(73) Proprietor: THE WHITAKER CORPORATION, Wilmington, Delaware 19808 (US)
(72) Inventor: OBATA, Hiroyuki, Kanagawa 214 (JP); SASAME, Naotaka, Higashikatsushika-gun,Chiba 277 (JP)
(74) Representative: Heinz-Schäfer, Marion
(86) International application number: US9712779
(87) International publication number: WO9804021

(56) References cited:
- WO-A-96/21257

## Description

This invention relates to assemblies of electric connectors and printed circuit boards used to connect modular connectors to other printed circuit boards.

A method of connecting a plurality of module or card-receiving connectors to selected circuits of a circuit element is described in Patent Application Hei6 (1994)-332573, which corresponds to U.S. Patent Nos. 5,324,204 and 5,401,176. According to the disclosure of the references, electric terminals of these several connectors are bent at one side in an L-shaped configuration and have connection sections intended for insertion into through-holes or openings formed in a circuit board. The card-receiving connectors are mounted on circuit boards in such a manner that the direction in which components to be joined thereto are nearly parallel to the printed circuit board.

However, when a module or card-receiving connector of the above mentioned design is mounted on a circuit board (mother board), it is difficult to align the connecting sections of the terminals with the through-holes. In cases with a large number of terminals, it may even be necessary to use a special alignment device. Since the connecting sections must be arrayed with an appropriate space between them, the terminals require rather a large area for their connection to the mother board. In addition, it is difficult to remove such a card-receiving connector assembly once it is mounted on a board, even when it is necessary to change the configuration of an electronic device.

Another card-receiving connector is disclosed in WO 96/21257. This application shows a memory card connector which comprises a header and a carrier connected to the header, wherein the header is provided with a plurality of pins extended in both inward and outward directions.

The inward pins are used for inserting a memory card to be received in the carrier. A vertical circuit board is electrically and securely connected to the outward pins of the header. The lower end of the vertical circuit board is detachably inserted into a connector securely mounted to the surface of a mainboard for electrical connection.

The purpose of this invention is to offer an assembly of a connector and a circuit board that makes it easier to connect card-receiving connectors to printed circuit boards and an assembly that occupies less space on the board. Additionally the assembly makes it easier to replace the module or card-receiving connector as required.

These objects are achieved by an assembly with the features of claim 1.

This invention offers an assembly of connector and a printed circuit board comprising a card-receiving connector having several connectors with electric terminals extending from one side, and a multilayer circuit board comprising a plurality of independently wired circuits to which corresponding ones of said terminals are connected. The multilayer circuit board of the assembly is rigid and is provided with pads that are connectable to contacts of an edge connector mounted on another printed circuit board.

In one embodiment of the invention the multilayer circuit board includes circuits arranged on both sides of grounding surfaces. In a further embodiment of the invention, the terminals of the card-receiving connector are arranged parallel to each other on one side of the connector. The connecting sections of the terminals that connect the terminals to the multilayer circuit board are straight and oriented perpendicularly to the multilayer circuit board. When the card-receiving connector consists of two connectors and the multilayer circuit board has four layers of circuits, the above mentioned grounding surface can be arranged on at least one side of the two middle layers and the two outer layers can have signal circuits corresponding to the terminals of the two connectors. It is also desirable to attach the card-receiving connector to the mother board by a mechanical means, and it is also desirable that such an attachment means has some mobility in the direction of the plane of the mother board.

Details of embodiments of the assembly of connector and circuit board according to this invention will now be described with reference to accompanying drawings in which:

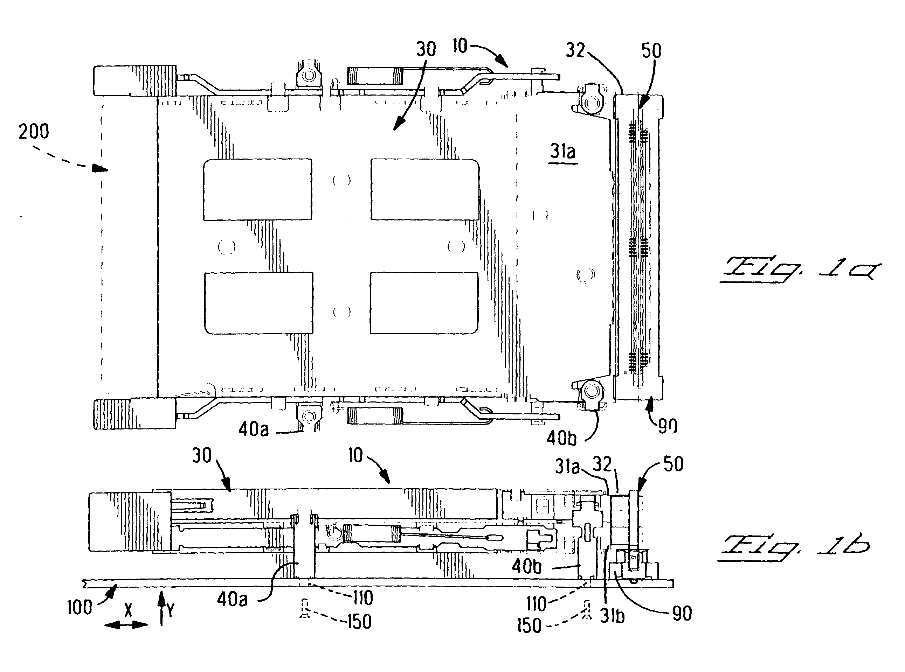

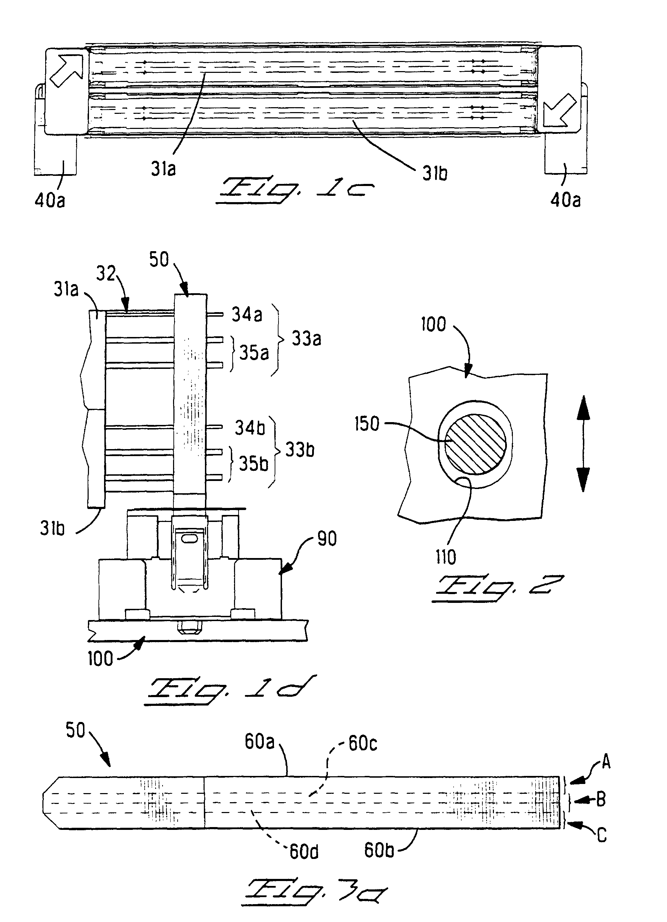

FIGURE 1 illustrates the assembly of connector and the first and second printed circuit boards, where 1a is a top plan view, 1b is a view of the right side, 1c is a front view, and 1d is an enlarged fragmentary view of the assembly illustrating the connection of the multilayer printed circuit board shown in Figure 1b to the mother board. In Figure 1a, PC cards inserted in the card-receiving connector are shown by broken lines; in Figure 1b, the holes through the printed circuit board and the fasteners used for the attachment of the assembly to the printed circuit board (mother board) are shown by broken lines.
FIGURE 2 is an enlarged view of openings made in the mother board for the fasteners used in attaching the card-receiving connector 30 of Figure 1 to the mother board.
FIGURE 3 illustrates a design of the multilayer circuit board, where 3a is a side view and 3b through 3e are views of the exterior and various circuit layers with 3b being the first layer, 3c the second layer; 3d the third layer and 3e the fourth layer.

According to Figures 1a through 1c, the assembly 10 of connector and a mother board comprises a card-receiving connector 30, a second or auxiliary printed circuit board (auxiliary board) 50 and an edge connector 90. The auxiliary board 50 is a multilayer board having several layers of circuits. The card-receiving connector illustrated here is designed for electrical connection of PC cards based on the PCMCIA-standards.
As can be seen from Figure 1c, the card-receiving connector 30 consists of two card connectors 31a and 31b stacked one above the other that can receive two PCMCIA cards of Type I or Type II. As it is shown in Figure 1b, the connecting portions of terminals 32 extend from one side of card connectors 31a and 31b. As is shown in Figure 1a, the connecting portions of terminals 32 are arranged in horizontal rows. From Figure 1d, it can be seen that the terminals 32 are clustered in two groups: the first group 33a and the second group 33b corresponding to card connectors 31a and 31b, respectively. Within each group of terminals 33a and 33b, the upper rows of terminals 34a, 34b are grounding terminals, and the lower rows of terminals 35a, 35b are signal terminals. Terminals 32 are connected to the multilayer auxiliary board 50 by inserting them into through-holes in the board and soldering them thereto, thus providing electrical connection for several layers of circuits. The structure of multilayered auxiliary circuit board is discussed below.

As is shown in Figures 1b and 1d, the auxiliary circuit board 50 is connected to the mother printed circuit board 100 by means of an edge connector 90. Contacts (not shown) of the edge connector 90 are joined to the wiring pads formed on the mother circuit board 100, thus providing for the electric connection of multilayered circuits of the auxiliary board 50 to the mother board 100. Therefore, PC cards 200, shown in phantom in Figure 1a, inserted into the card-receiving connector 30 become connected to the mother board 100 via the assembly of the connector 30 and auxiliary board 50.

As is shown in Figures 1a through 1c, the card-receiving connector 30 has fixtures 40a, 40b provided for the attachment of the connector 30 to the mother board. The fixtures may be made from metal or other suitable material. Fixtures 40a, 40b include threaded openings (not shown) for receiving fasteners, such as screws 150, or the like. The card-receiving connector 30 is fixed to the printed circuit board 100 by fasteners 150 passed through openings 110 made in the printed circuit board 100 and into the corresponding openings in fixtures 40a and 40b.

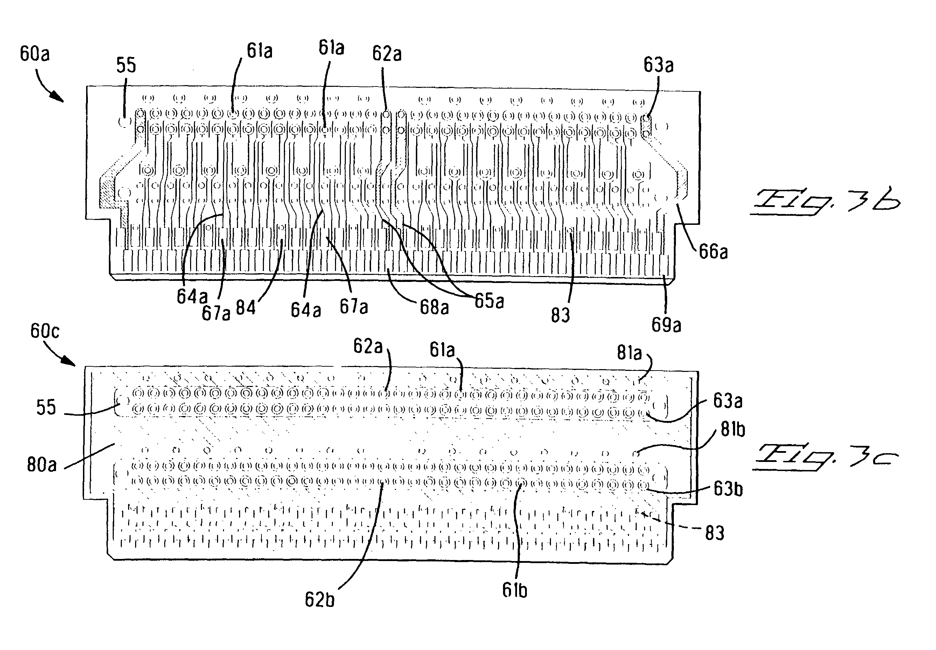

Figure 2 represents a fragmentary enlarged view of the opening 110 and a cross section of the fastener 150 as seen in the direction shown by arrow Y in Figure 1b. Direction X in Figure 1b corresponds to the lengthwise direction of the card-receiving connector 30. Since the openings 110 provided for the attachment of the card-receiving connector 30 are larger than the diameter of the shaft of fasteners 150, the card-receiving connector 30 has some tolerance regarding the mounting position on the mother board 100. A detailed explanation regarding the design of a card-receiving module or connector can be found in Japanese Patent Disclosure Hei 7 (1995)-335318.

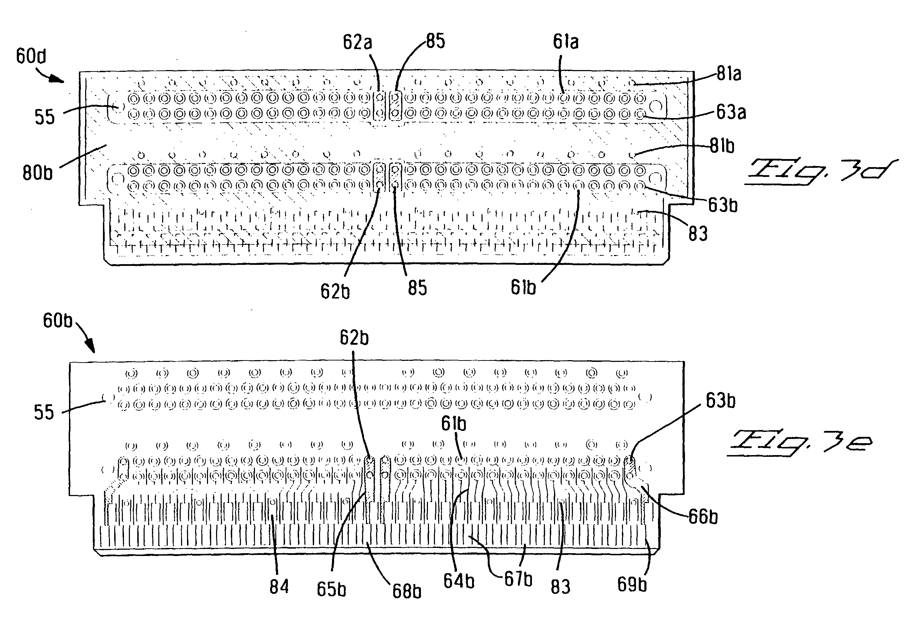

Figure 3 illustrates the design of the multilayer auxiliary printed circuit board 50, where 3a is side view, and 3b through 3e are schematic drawings depicting the exterior of the board and different layers thereof. Figures 3b through 3d extending in the same direction, and 3e shows a circuit extending in the opposite direction. According to Figure 3a, the auxiliary board 50 consists of a total of four layers of circuits. The layers are separated from each other by an insulating material. Circuits 60a and 60b located in the outside layers one and four contain mostly signal wiring, and circuits 60c and 60d contain mostly grounding wiring.

Figure 3b depicts the circuit 60a of the first layer containing mostly signal wiring. Circuit 60a has a plurality of signal conductive paths 64a connecting through-holes 61a receiving the terminals 32 of the contact row 35a extending from connector 31a of the card-receiving connector 30 to pads 67a for electrical engagement way of contacts with edge connector 90. In approximately the middle of the circuit 60a, a pair of power wiring paths 65a are formed that connect through-holes 62a with the power source pads 68a. Near the both sides of the circuit 60a, the ground wiring paths 66a are formed that connect circuit grounding through-holes 63a to the grounding pads 69a.

Figure 3e depicts another circuit 60b containing mostly signal wiring of the fourth layer. The circuit 60b has a plurality of signal conductive paths 64b connecting through-holes 61b receiving the terminals 32 of the contact rows 35b extending from the connector 31 of the card-receiving connector 30 to pads 67b for electrical engagement with contacts of edge connector 90. Conductive paths 64b are shorter than the conductive paths 64a shown in Figure 3b. In approximately the middle of the circuit 60b, a pair of power wiring paths 65b are formed which connect through-holes 62b with the power source pads 68a. Near the both sides of the circuit 60b, the grounding wiring paths 66b are formed which connect circuit grounding through-holes 63b to the grounding pads 69b.

Figures 3c and 3d depict circuits 60c and 60d containing mostly grounding wiring and located in the second and the third layers respectively. Circuits 60c and 60d consist of the grounding surfaces 80a and 80b covering the entire area except for the through-holes 61a, 61b; power source through-holes 62a, 62b and the circuit grounding through-holes 63a, 63b. Both grounding surfaces 80a, 80b provide electrical connections between grounding terminals of contact rows 34a, 34b of terminals 32 and grounding holes 81a, 81b. In addition, grounding surfaces 80a, 80b provide electrical connection for the grounding pads 84 made on the circuits 60a, 60b of the first and the second layers by means of the grounding pad through-hole 83, see Figures 3b and 3c. Circuit 60d of the third layer includes commoning conductor 85 that commons the respective pairs of power source through-holes 62a, 62b together.

Figure 3a, illustrates the method of fabrication of the auxiliary board 50. The auxiliary board 50 is made by adhering together three sections, A, B and C. Section A is made by forming the circuit 60a of the forming the circuit 60b of the fourth layer on a plastic sheet. Section B is made by forming circuits 60c, 60d of the second and third layers on opposite sides of a plastic sheet. Sections A and C are adhered to the top and the bottom of section B by an adhesive material. After that, the auxiliary board 50 is finished by making the respective through-holes.

The auxiliary board 50 is prepared in such a manner that one of its sides, either circuit 60a of the first layer or 60b of the fourth layer faces the card-receiving connector 30. At that time, an alignment plate (not shown) can be used for aligning the terminals of card-receiving connector 30. By using an alignment or tie-in plate, contacts 32 of the card-receiving connector 30 can be smoothly inserted in the through-holes 61a, 61b, 62a, 62b, 63a, 63b. In order to correctly position the alignment plate against the auxiliary board 50, special alignment openings 55 are made in the auxiliary board 50. Terminals 32 are soldered to the auxiliary board 50 on the side opposite to the card-receiving connector 30.

The explanation above describes one embodiment of the assembly of electric connector and printed circuit board according to this invention. However, this invention is not limited only to the embodiment described above and various modifications can be made experts in the field.

The assembly of electric connector and printed circuit board according to this invention comprises a stacked card-receiving connector made of several connectors having respective electric terminals extending in several rows from one side of the connectors to respective pads of a multilayer printed circuit board having several layers of circuits connected to independently wired circuit layers sandwiching grounding surfaces, with the multilayer printed circuit board being equipped with pads that are joined to contacts of an edge connector mounted on another or mother circuit board.

A first advantage of the invention is the card-receiving connector can be easily connected to a mother board due to the fact that such a connection can be implemented just by inserting the auxiliary multilayer printed circuit board into an edge connector. A second advantage is that even with an increase in the number of connectors in the card-receiving connector, the mounting area on the mother board remains relatively small, thus making it possible to increase the packing density of electric components. The third advantage consists of the fact that the card-receiving connector can be easily replaced with a more suitable unit in the event of changes in specifications.

## Claims

1. An assembly (10) of connector and printed circuit board (100) consisting of a card receiving connector (30) having several connectors (31a,31b) with electric terminals (32) extending from one side, the assembly (10) being **characterized by** a multilayer circuit board (50) comprising a plurality of independently wired circuits (60a,60b) to which corresponding ones of said terminals (32) of said card connector (30) are connected and in that
said multilayer circuit board (50) is provided with pads that are joined to contacts of an edge connector (90) mounted on the printed circuit board (100).

2. The assembly of claim 1 wherein said multilayer circuit board includes circuits arranged on both sides of grounding surfaces (80a,80b).

3. The assembly of claim 1 wherein said connectors (31a, 31b) are in a stacked arrangement with the respective terminals (32) of said connectors arranged parallel to each other on one side of the connector (30).

## Patentansprüche

1. Anordnung (10) von Verbinder und Leiterplatte (100), die aus einem K-artenaufhahmeverbinder (30) mit mehreren Verbindern (31a, 31b) besteht, wobei sich elektrische Anschlußklemmen (32) von einer Seite aus erstrecken, wobei die Anordnung (10) **gekennzeichnet ist durch** eine Mehrlagenleiterplatte (50), die eine Vielzahl von unabhängig verdrahteten Schaltkreisen (60a, 60b) aufweist, mit denen die entsprechenden Anschlußklemmen (32) des Kartenverbinders (30) verbunden sind, und **dadurch**, daß
die Mehrlagenleiterplatte (50) mit Anschlußflächen versehen ist, die mit Kontakten eines Randverbinders (90) verbunden sind, der auf der Leiterplatte (100) montiert ist.

2. Anordnung nach Anspruch 1, bei der die Mehrlagenleiterplatte Schaltkreise umfaßt, die auf beiden Seiten von Erdungsflächen (80a, 80b) angeordnet sind.

3. Anordnung nach Anspruch 1, bei der die Verbinder (31a, 31b) in einer gestapelten Anordnung vorhanden sind, wobei die entsprechenden Anschlußklemmen (32) der Verbinder parallel zueinander auf einer Seite des Verbinders (30) angeordnet sind.

## Revendications

1. Assemblage (10) d'un connecteur et d'une plaquette de circuit imprimé (100) comprenant un connecteur de carte enfichable (30) comportant plusieurs connecteurs (31a, 31b) avec des bornes électriques (32) s'étendant à partir d'un côté, l'assemblage (10) étant **caractérisé par** une plaquette de circuit multicouche (50) comprenant plusieurs circuits à câblage indépendant (60a, 60b) auxquels sont connectées lesdites bornes correspondantes (32) dudit connecteur de carte (30) et en ce que
ladite plaquette de circuit multicouche (50) comporte des plots reliés aux contacts d'un connecteur latéral (90) monté sur la plaquette de circuit imprimé (100).

2. Assemblage selon la revendication 1, dans lequel ladite plaquette de circuit multicouche englobe des circuits agencés sur les deux côtés de surfaces de mise à la terre (80a, 80b).

3. Assemblage selon la revendication 1, dans lequel lesdits connecteurs (31a, 31b) constituent un agencement empilé, des bornes respectives (32) desdits connecteurs étant agencées parallèlement les unes aux autres sur un côté du connecteur (30).
